# FASCICULE DE BREVET EUROPEEN

(11) **EP 3 341 976 B1**
(45) Date de publication et mention de la délivrance du brevet: **13.11.2019**
(21) Numéro de dépôt: 16742305.2
(22) Date de dépôt: 25.07.2016
(51) Int. Cl.: H01L 35/30, F01N 5/02, H01L 35/32

(54) **MODULE THERMOELECTRIQUE POUR GENERATEUR THERMOELECTRIQUE**
THERMOELEKTRISCHES MODUL FÜR EINEN THERMOELEKTRISCHEN GENERATOR
THERMOELECTRIC MODULE FOR A THERMOELECTRIC GENERATOR

(30) Priorité: 25.08.2015 FR 1557913
(43) Date de publication de la demande: 04.07.2018
(73) Titulaire: Valeo Systemes Thermiques, 78320 Le Mesnil Saint Denis (FR)
(72) Inventeur: AZZOUZ, Kamel, 75012 Paris (FR); TRAORE, Issiaka, 92400 Courbevoie (FR)
(74) Mandataire: Tran, Chi-Hai
(86) Numéro de dépôt international: PCT/EP2016/067648
(87) Numéro de publication internationale: WO 2017/032526

(56) Documents cités:
- EP-A1- 2 541 634
- DE-A1-102009 003 144
- US-A1- 2006 180 192

## Description

### Domaine de l'invention

L'invention concerne un module thermoélectrique, un dispositif thermoélectrique comprenant un agencement d'une pluralité de modules thermoélectriques, et un générateur thermoélectrique comprenant au moins un dispositif thermoélectrique.

### Etat de la technique

Dans le domaine automobile, il a déjà été proposé des générateurs comprenant une pluralité de modules thermiques utilisant des éléments thermoélectriques permettant de produire un courant électrique en présence d'un gradient de température entre deux de leurs faces opposées selon le phénomène connu sous le nom d'effet Seebeck. Ces modules comprennent un empilement de premiers tubes, destinés à la circulation des gaz d'échappement d'un moteur, et de seconds tubes, destinés à la circulation d'un fluide caloriporteur d'un circuit de refroidissement. Les éléments thermoélectriques sont pris en sandwich entre les tubes de façon à être soumis à un gradient de température provenant de la différence de température entre les gaz d'échappement, chauds, et le fluide de refroidissement, froid.

De tels générateurs sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans celui-ci pour générer de l'électricité à partir d'une courroie entrainée par le vilebrequin du moteur.

On distingue classiquement les éléments thermoélectriques de forme géométrique parallélépipédique et cylindrique.

Pour un module thermoélectrique comprenant des éléments thermoélectriques parallélépipédiques, le gaz chaud passe à travers le canal d'un tube plat en inox. Ensuite il échange la chaleur avec les plots dont les surfaces opposées sont en contact avec une source froide liquide. Les connexions entre les plots thermoélectriques se font alternativement entre les faces supérieures et inférieures, grâce à des pistes conductrices planes, brasées ou collées.

Pour un module thermoélectrique comprenant des éléments thermoélectriques cylindriques sous forme d'anneau, l'eau froide circule à l'intérieur d'un tube traversant les anneaux, et le gaz chaud est amené par l'extérieur. Cette configuration permet de rééquilibrer les transferts de chaleur côté froid et côté chaud. En effet, avec une telle configuration, la surface d'échange côté chaud est plus importante, ce qui améliore le transfert de chaleur vers les anneaux sachant que le coefficient d'échange côté gaz chaud est plus faible que côté liquide froid. Les connexions entre les anneaux se font alternativement par l'intérieur puis par l'extérieur des anneaux au moyen de liaisons conductrices tubulaires faisant office d'électrodes métalliques.

La géométrie cylindrique est préférée à la géométrie parallélépipédique, en terme de rendement calorifique comme expliqué ci-dessus.

L'objectif de la présente invention consiste à améliorer encore ce rendement calorifique, en optimisant les surfaces d'échanges.

US 2006/180192 divulgue un module thermoélectrique comprenant un ensemble thermoélectrique central et périphérique de forme cylindrique.

DE 10 2009 003144 divulgue un module thermoélectrique comprenant un ensemble thermoélectrique central à l'intérieur duquel circule un fluide froid et à l'extérieur duquel circule un fluide chaud.

### Résumé de l'invention

Ce but est atteint grâce à un module thermoélectrique, comprenant de façon classique un ensemble thermoélectrique central de forme tubulaire cylindrique à l'intérieur duquel circule un premier fluide froid et à l'extérieur duquel circule un fluide chaud.

Ce module se caractérise à titre principal en ce qu'il comprend également au moins un ensemble thermoélectrique périphérique présentant :
- une face externe en contact avec un second fluide froid ;
- une face interne disposée sur une limite périphérique entourant l'ensemble thermoélectrique central, ladite limite définissant un canal entre lesdits ensembles thermoélectriques central et périphérique où circule le fluide chaud.

L'idée principale de cette invention consiste à intégrer non plus un seul ensemble thermoélectrique, mais une pluralité d'ensembles thermoélectriques agencés de manière à puiser les calories simultanément dans un même fluide chaud. La récupération d'énergie à partir de ce fluide chaud est donc optimisée.

Le module comprend un unique ensemble thermoélectrique périphérique disposé de façon continue sur la limite périphérique.

Dans ce cas, l'idée consiste à « densifier » le module thermoélectrique, en intégrant un second ensemble thermoélectrique, de grand diamètre, autour du premier ensemble thermoélectrique central, dans le but de piéger intégralement la chaleur apportée par le fluide chaud, c'est-à-dire le gaz. Ainsi, le fluide chaud circule simultanément à l'extérieur du premier ensemble thermoélectrique central d'une part, et à l'intérieur du second ensemble thermoélectrique périphérique d'autre part.

Dans cette configuration, différents modes de réalisation du module de l'invention, tels que décrits ci-après, pourront être pris ensemble ou séparément :
- l'ensemble thermoélectrique central se trouve à l'intérieur de l'ensemble thermoélectrique périphérique.
- ledit ensemble thermoélectrique périphérique est de forme tubulaire cylindrique parallèle et concentrique avec l'ensemble thermoélectrique central.
- lesdits ensembles thermoélectriques central et périphérique sont chacun formés par un alignement d'éléments thermoélectriques de forme annulaire, reliés électriquement les uns aux autres et susceptibles de générer un courant électrique sous l'action d'un gradient de température exercé entre deux de leurs faces.
- ledit canal à l'intérieur duquel circule le fluide chaud a une section annulaire.
- le module comprend un tube isolant concentrique avec les ensembles thermoélectriques central et périphérique et venant entourer l'ensemble thermoélectrique périphérique tout en définissant un canal de section annulaire pour la circulation du second fluide froid autour de l'ensemble thermoélectrique périphérique.
- le canal dans lequel circule le fluide chaud comprend des moyens de perturbation de l'écoulement du fluide chaud, afin d'améliorer l'échange thermique.
- lesdits moyens de perturbation de l'écoulement du fluide chaud consistent en des ailettes positionnées au sein du canal d'écoulement du fluide chaud et s'étendant depuis la face externe de l'ensemble thermoélectrique central et depuis la face interne de l'ensemble thermoélectrique périphérique.
- lesdites ailettes s'étendant depuis les ensembles thermoélectriques central et périphérique sont disposées en quinconce.
- les ensembles thermoélectriques central et périphérique sont reliés électriquement en parallèle.

L'invention concerne également un dispositif thermoélectrique comprenant un agencement d'une pluralité de modules thermoélectriques tels que décrits ci-dessus. Ces modules thermoélectriques peuvent être disposés en ligne ou en quinconce par exemple.

L'invention concerne aussi un générateur thermoélectrique comprenant au moins un dispositif thermoélectrique tel que décrit ci-dessus.

### Présentation des figures

L'invention sera mieux comprise, et d'autres buts, détails, caractéristiques et avantages de celle-ci apparaîtront plus clairement au cours de la description explicative détaillée qui va suivre, d'au moins un mode de réalisation de l'invention donné à titre d'exemple purement illustratif et non limitatif, en référence aux dessins schématiques annexés.

Sur ces dessins :
- la figure 1 illustre un module thermoélectrique de géométrie cylindrique, en vue de coupe longitudinale, selon l'art antérieur.
- la figure 2 illustre le module thermoélectrique de la figure 1 en vue de coupe transversale ;
- la figure 3 montre un module thermoélectrique selon un premier mode qui relève de l'invention, en vue de coupe transversale ;
- la figure 4 montre un dispositif thermoélectrique composé d'un agencement de modules thermoélectriques selon la figure 3, en vue de coupe transversale ;
- la figure 5 montre un module thermoélectrique selon un deuxième mode qui ne relève pas de l'invention, en vue de coupe transversale ;
- la figure 6 montre un dispositif thermoélectrique composé d'un agencement de modules thermoélectriques selon la figure 5, en vue de coupe transversale ;
- la figure 7 représente l'agencement de tubes plats pour la circulation de fluide froid dans le dispositif thermoélectrique de la figure 6 ;
- la figure 8 représente l'agencement de tubes pour la circulation de fluide chaud dans le dispositif thermoélectrique de la figure 6 ;
- la figure 9 représente l'agencement de tubes ronds pour la circulation de fluide froid dans le dispositif thermoélectrique de la figure 6 ;
- la figure 10 est une vue schématique d'un échangeur doté de deux circuits distincts de fluide froid, adapté pour fonctionner avec un dispositif thermoélectrique selon l'invention ;
- la figure 11 est une vue schématique d'un échangeur doté d'un seul circuit de fluide froid, adapté pour fonctionner avec un dispositif thermoélectrique selon l'invention ;
- la figure 12 est une vue éclatée en perspective d'un ensemble échangeur dispositif thermoélectrique selon l'invention.

### Description détaillée

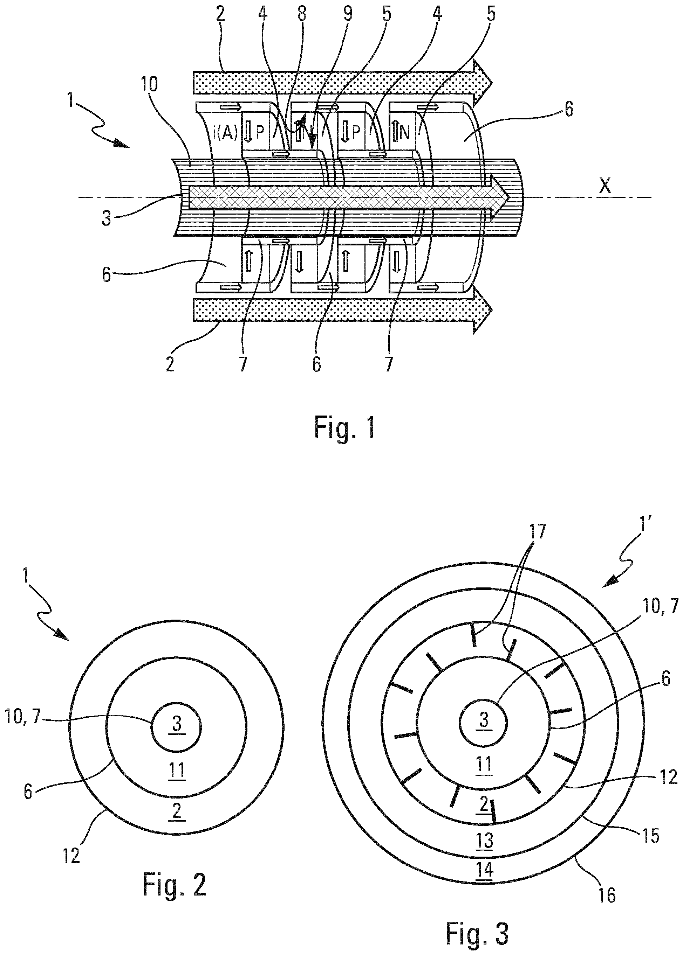

La figure 1 illustre un exemple de module 1 thermoélectrique classique.

Ce module comprend ici un premier canal 2 apte à permettre la circulation d'un fluide chaud, notamment des gaz d'échappement d'un moteur, et un second canal 3 apte à permettre la circulation d'un fluide froid, notamment un fluide caloporteur d'un circuit de refroidissement, de température inférieure à celle du fluide chaud. Ce fluide froid circule au sein d'un tube 10, d'axe central X.

Le module 1 comprend une pluralité d'éléments 4, 5 thermoélectriques, ici de formes annulaires, susceptibles de générer un courant électrique sous l'action d'un gradient de température exercé entre deux de leurs faces, l'une 8, dite première face active, étant définie par une surface de périphérie extérieure, cylindrique, et l'autre 9, dite seconde face active, étant définie par une surface de périphérie intérieure, cylindrique. Lesdites première et seconde faces 8,9 sont, par exemple, de section circulaires. De façon plus générale, toute section de forme arrondie et/ou polygonale est possible.

De tels éléments 4, 5 fonctionnent, selon l'effet Seebeck, en permettant de créer un courant électrique dans un connecteur électrique 6, 7 connecté entre lesdites faces 8,9 soumises au gradient de température. De façon connue de l'homme du métier, de tels éléments 4, 5 sont constitués, par exemple, de Bismuth et de Tellurium (Bi2Te3).

Les éléments 4, 5 thermoélectriques pourront être, pour une première partie, des éléments 4 d'un premier type, dit P, permettant d'établir une différence de potentiel électrique dans un sens, dit positif, lorsqu'ils sont soumis à un gradient de température donné, et, pour l'autre partie, des éléments 5 d'un second type, dit N, permettant la création d'une différence de potentiel électrique dans un sens opposé, dit négatif, lorsqu'ils sont soumis au même gradient de température.

Les éléments 4, 5 thermoélectrique représentés sur toutes les figures sont constitués d'un anneau en seule pièce. Ils pourront cependant être formés de plusieurs pièces formant chacune une portion angulaire de l'anneau.

Sur la figure 1, lesdits éléments 4, 5 thermoélectriques sont disposés, par exemple, dans le prolongement longitudinal l'un de l'autre, notamment de façon coaxiale selon l'axe X ; ils alternent entre éléments P et éléments N. Ils sont, notamment, de forme et de dimension identiques. Ils pourront cependant présenter une épaisseur, c'est-à-dire une dimension entre leurs deux faces planes, différente d'un type à l'autre, notamment en fonction de leur conductivité électrique.

Lesdits éléments 4, 5 thermoélectriques sont, par exemple, groupés par paire, chaque paire étant formée d'un dit élément 4 thermoélectrique de type P et d'un dit élément 5 thermoélectrique de type N, et ledit module 1 est configuré pour permettre une circulation de courant entre les premières faces actives 8 des éléments thermoélectriques d'une même paire et une circulation de courant entre les secondes faces actives 9 de chacun des éléments thermoélectriques de ladite même paire et l'élément thermoélectrique voisin de la paire voisine. On assure de la sorte une circulation en série du courant électrique entre les éléments thermoélectriques 8,9 disposés les uns à côtés des autres, comme illustré par les petites flèches.

Le module 1 comprend en outre des connecteurs 6, 7 entre les premier et deuxième éléments 4, 5 thermoélectriques. Ces connecteurs 6, 7 sont en forme de bague d'axe central X. Une bague d'un premier type 6 est systématiquement prévue entre un élément 5 thermoélectrique de type N et un élément 4 thermoélectrique de type P. Une bague d'un second type 7 est systématiquement prévue entre un élément 4 thermoélectrique de type P et un élément 5 thermoélectrique de type N.

Lesdites bagues 6, 7 diffèrent par leur diamètre. Ainsi, la bague 6 prévue entre un élément 5 thermoélectrique de type N et un élément 4 thermoélectrique de type P sera d'un diamètre supérieur à la bague 7 prévue entre ledit élément 4 thermoélectrique de type P et l'élément 5 thermoélectrique de type N suivant.

Autrement dit, pour le module 1 thermoélectrique, deux jeux de bagues 6, 7 de tailles différentes sont nécessaires : un premier pour la liaison électrique côté canal 3 de la source froide et un second, de diamètre supérieur, pour le côté canal 2 de la source chaude.

En résumé, ce module 1 thermoélectrique selon l'art antérieur, en vue de coupe transversale sur la figure 2, se compose des éléments suivants, depuis l'intérieur vers l'extérieur :
- un canal 3 de circulation d'un fluide froid délimité par un tube 10
- un ensemble thermoélectrique central 11 formé par les éléments thermoélectriques 4,5 entourés d'électrodes internes 7 et externes 6
- un canal 2 de circulation d'un fluide chaud délimité par un tube 12

Le module 1' thermoélectrique selon un premier mode de réalisation de l'invention, en vue de coupe transversale sur la figure 3, se compose des éléments suivants, depuis l'intérieur vers l'extérieur :
- un canal 3 de circulation d'un premier fluide froid délimité par un tube 10
- un ensemble thermoélectrique central 11 formé par les éléments thermoélectriques 4,5 entourés d'électrodes internes 7 et d'électrodes externes 6
- un canal 2 de circulation d'un fluide chaud
- un ensemble thermoélectrique périphérique 13 formé par des éléments thermoélectriques entourés d'électrodes internes 12 et externes 15
- un canal 14 de circulation d'un second fluide froid délimité par un tube 16 isolant de préférence.

Ce module 1' correspond au module 1 de l'art antérieur, auquel se rajoute un ensemble thermoélectrique périphérique 13 avec ses électrodes interne 12 et externe 15. Il y a donc une deuxième couche d'éléments thermoélectriques, aptes à puiser les calories dans le même fluide chaud. Le module 1' thermoélectrique est ainsi « densifié », et optimise le transfert de chaleur.

Plus précisément, les canaux 3, 2, 14, les électrodes 7, 6, 12, 15, les ensembles thermoélectriques 11,13 sont tous concentriques selon l'axe X. Par conséquent, les canaux de circulation du fluide chaud 2 et du second fluide froid 14 ont des sections transversales de forme annulaire.

Les ensembles thermoélectriques central 11 et périphérique 13 sont ainsi disposés en parallèle thermiquement, et sont également reliées en parallèle électriquement.

Les deux ensembles thermoélectriques 11,13 sont composés d'éléments thermoélectriques annulaires, rangés les uns à côté des autres pour former des tubes creux. Les éléments thermoélectriques de l'ensemble central 11 ont un diamètre inférieur aux éléments thermoélectriques de l'ensemble périphérique 13. Le diamètre des éléments thermoélectriques de l'ensemble périphérique 13 est adapté en fonction de la résistance électrique de l'ensemble et en fonction du flux thermique disponible.

Le fluide chaud est ainsi emprisonné entre d'une part la face externe de l'ensemble thermoélectrique central 11, et d'autre part une limite périphérique constituée par la face interne de l'ensemble thermoélectrique périphérique 13. La surface d'échange a ainsi plus que doublé par rapport à l'art antérieur, rendant le module 1' très performant.

Afin d'augmenter encore les performances de rendement énergétique, des ailettes 17 sont disposées dans le canal 2 de circulation du fluide chaud. Ces ailettes 17 perturbent la circulation du fluide chaud, et créent ainsi des turbulences, empêchant le fluide chaud de circuler trop vite afin que la face externe de l'ensemble thermoélectrique central 11 et la face interne de l'ensemble thermoélectrique périphérique 13 aient le temps de capter les calories. Ces ailettes 17 présentent également en elles-mêmes des surfaces supplémentaires d'échange de chaleur avec le fluide chaud.

De préférence, la moitié des ailettes 17 s'étend depuis la face externe de l'ensemble thermoélectrique central 11 et l'autre moitié des ailettes 17 s'étend depuis la face interne de l'ensemble thermoélectrique périphérique 13.

Les ailettes 17 sont disposées en quinconce afin de guider le fluide chaud à travers un chemin ondulé, ou en zigzag. Cette disposition alternée permet donc de perturber l'écoulement du flux et ainsi améliorer l'échange thermique.

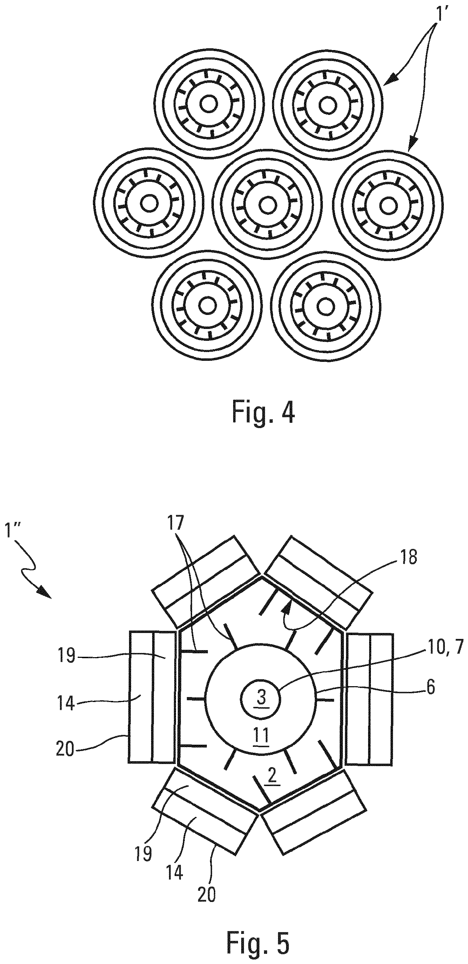

La figure 4 montre une illustration pratique sur la disposition des modules 1' thermoélectriques « densifiés » selon l'invention, formant un dispositif thermoélectrique utilisé dans un générateur. Dans cet exemple, les modules 1' sont disposés en ligne sur trois rangées, et en quinconce d'une rangée à l'autre, afin d'obtenir un dispositif compact. Le nombre de lignes peut bien entendu varier, tout comme le nombre de modules 1' par ligne.

Le module 1" thermoélectrique selon un deuxième mode de réalisation de l'invention, mode qui ne fait pas partie de l'invention, en vue de coupe transversale en figure 5, se compose des éléments suivants, depuis l'intérieur vers l'extérieur :
- un canal 3 de circulation d'un premier fluide froid délimité par un tube 10
- un ensemble thermoélectrique central 11 formé par les éléments thermoélectriques 4,5 entourés d'électrodes internes 7 et d'électrodes externes 6
- un canal 2 de circulation d'un fluide chaud dont la limite périphérique est constituée par un tube 18 dont la section comporte une pluralité de côtés ;
- des ensembles thermoélectriques périphériques 19 placés sur chaque côté du tube 18 ;
- des canaux 14 de circulation d'un second fluide froid délimités par des tubes 20.

Ce module 1" correspond au module 1 de l'art antérieur, auquel on rajoute une pluralité d'ensembles thermoélectriques périphériques 19 disposés tout autour de l'ensemble thermoélectrique central 11. Le module 1" a donc une architecture en étoile, avec une pluralité d'ensembles thermoélectriques périphériques 19 entourant de façon discontinue l'ensemble thermoélectrique central 11. A nouveau, il existe une deuxième couche d'éléments thermoélectriques, aptes à puiser les calories dans le même fluide chaud. Le module 1" thermoélectrique est ainsi « densifié », et optimise le transfert de chaleur.

Dans l'exemple présenté, le tube 18 est hexagonal, son axe de symétrie étant confondu avec l'axe central X. La dimension du tube 18 est adaptée en fonction du bilan thermique intervenant dans les éléments thermoélectriques du module 1".

Le module 1" comporte six ensembles périphériques 19 venant chacun se positionner contre un côté du tube 18, et sur toute la largeur du côté de manière à proposer une surface d'échange thermique maximale avec le tube 18.

Ainsi, seules les six arêtes du tube 18 ne sont pas en contact avec un module thermoélectrique périphérique 19.

Pour pouvoir s'étendre sur toute la largeur du côté du tube 18, chaque ensemble thermoélectrique périphérique 19 présente une face interne plane d'une largeur équivalente à celle d'un côté du tube 18. Pour se faire, les ensembles thermoélectriques périphériques 19 sont formés par un alignement d'éléments thermoélectriques ayant une géométrie parallélépipédique. Le fluide chaud est ainsi emprisonné entre d'une part la face externe de l'ensemble thermoélectrique central 11, et d'autre part le tube 18 hexagonal en contact avec la face interne des ensembles thermoélectriques périphériques 19. La surface d'échange a ainsi plus que doublé par rapport à l'art antérieur, rendant le module 1" très performant.

Par cette géométrie parallélépipédique, la face externe des ensembles thermoélectriques périphériques 19 est également plane. Cette face externe échange des calories avec un second fluide froid. De façon avantageuse, ce second fluide froid circule dans un canal 14 délimité par un tube plat 20 de section rectangulaire, positionné contre ladite face externe, et dont les dimensions s'adaptent à celles de la face externe afin d'offrir la plus grande surface d'échange thermique. Le positionnement d'un tube plat 20 sur un ensemble thermoélectrique périphérique 19 de géométrie parallélépipédique permet un assemblage aisé et simple de mise en œuvre.

Tout comme dans le premier mode de réalisation, des ailettes 17 en forme d'aiguilles ou des perturbateurs sont placés dans le canal 2 de circulation du fluide chaud afin de créer des turbulences. Ces ailettes/perturbateurs 17 s'étendent depuis le tube hexagonal 18 ou depuis la face externe de l'ensemble thermoélectrique central 11, en vue d'améliorer et d'intensifier les échanges de chaleur favorables à l'efficacité des éléments thermoélectriques.

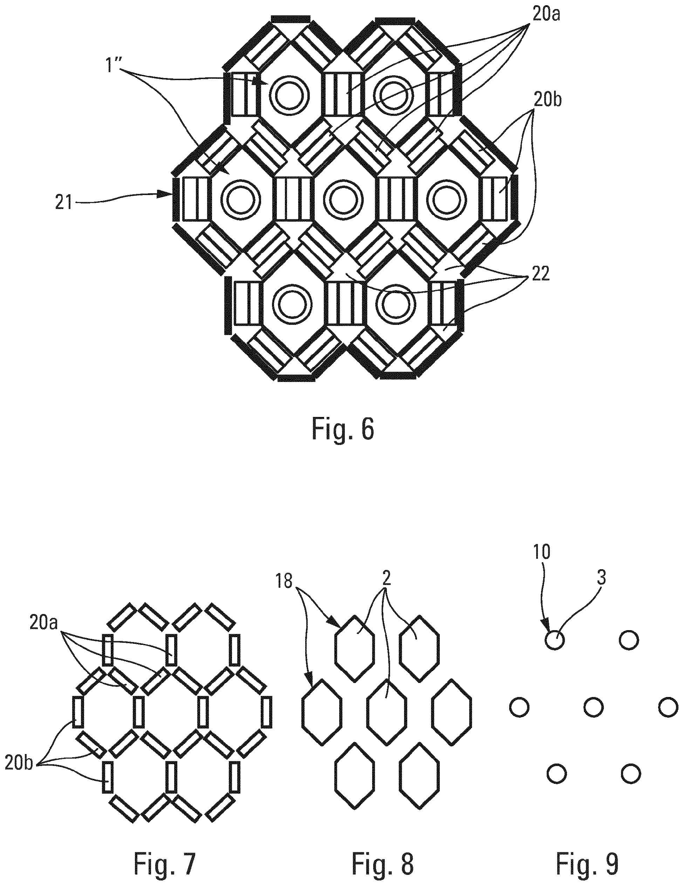

La figure 6 montre une illustration pratique sur la disposition des modules 1" thermoélectriques selon ce deuxième mode de réalisation, formant un dispositif thermoélectrique utilisé dans un générateur. Dans cet exemple, les modules 1" sont disposés en ligne sur trois rangées, et en quinconce d'une rangée à l'autre, afin d'obtenir un dispositif compact, ayant l'allure d'un nid d'abeille, chaque module 1" constituant une alvéole. Cet exemple n'est pas limitatif quant au nombre de modules 1" par dispositif.

La forme du dispositif en nid d'abeille est mieux représentée en figure 7. Seuls sont représentés les tubes plats 20 dans lesquels circule le second fluide froid. Il est bien visible qu'entre deux modules 1" adjacents, ne se trouve qu'un seul un tube plat 20a. Ce tube plat 20a est donc utilisé pour les deux modules 1" de façon simultanée. Il comporte une première face plane dirigée vers l'un des modules 1", et une seconde face plane dirigée vers l'autre module 1". Il existe donc une mutualisation des tubes plats 20a dans cette configuration en nid d'abeille. Les tubes plats 20b non mutualisés se trouvent en périphérie du nid d'abeille.

Dans chaque alvéole se trouve un tube hexagonal 18 formant le canal 2 pour le passage du fluide chaud comme illustré en figure 8, et dans chaque tube hexagonal 18 se trouve un tube rond 10 formant le canal 3 pour le passage du premier fluide froid comme illustré en figure 9. Il existe donc trois types de tubes 10,18,20 différents pour la distribution des fluides dans ce dispositif thermoélectrique.

Entre les alvéoles se trouvent des espaces de forme triangulaire, appelés volumes morts 22, dans lesquels cheminent des liaisons électriques reliant les ensembles thermoélectriques périphériques 19 entre eux.

Le dispositif est entouré par une enveloppe 21 externe isolante venant épouser la forme externe du nid d'abeille, et venant ainsi en contact avec les tubes plats 20b se trouvant en périphérie du nid et donc non mutualisés. Cette enveloppe 21 permet d'éviter la dissipation des calories du fluide froid vers l'extérieur.

Ce concept de dispositif en nid d'abeille permet de mettre en œuvre différentes configurations d'échangeurs au sein du générateur thermoélectrique.

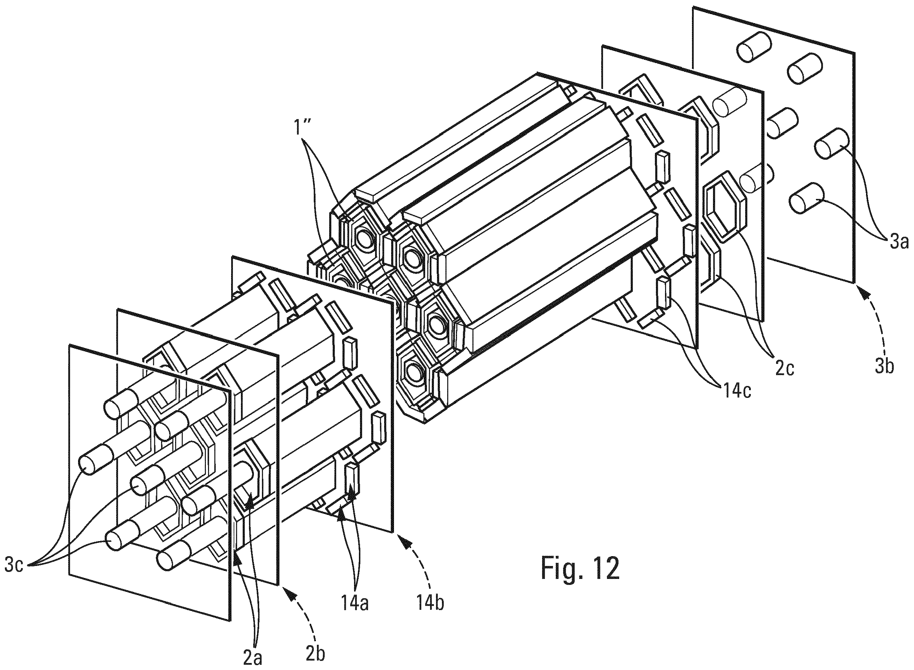

La figure 12 illustre différentes parties d'un échangeur par rapport au dispositif en nid d'abeille. Cet échangeur comprend :
- une entrée 3a du premier fluide froid
- une zone de distribution 3b du premier fluide froid dans les tubes ronds 10
- une sortie 3c du premier fluide froid
- une entrée 2a du fluide chaud (gaz)
- une zone de distribution 2b du fluide chaud dans les tubes hexagonaux 18
- une sortie 2c du fluide chaud
- une entrée 14a du second fluide froid
- une zone de distribution 14b du second fluide froid dans les tubes rectangulaires 20
- une sortie 14c du second fluide froid

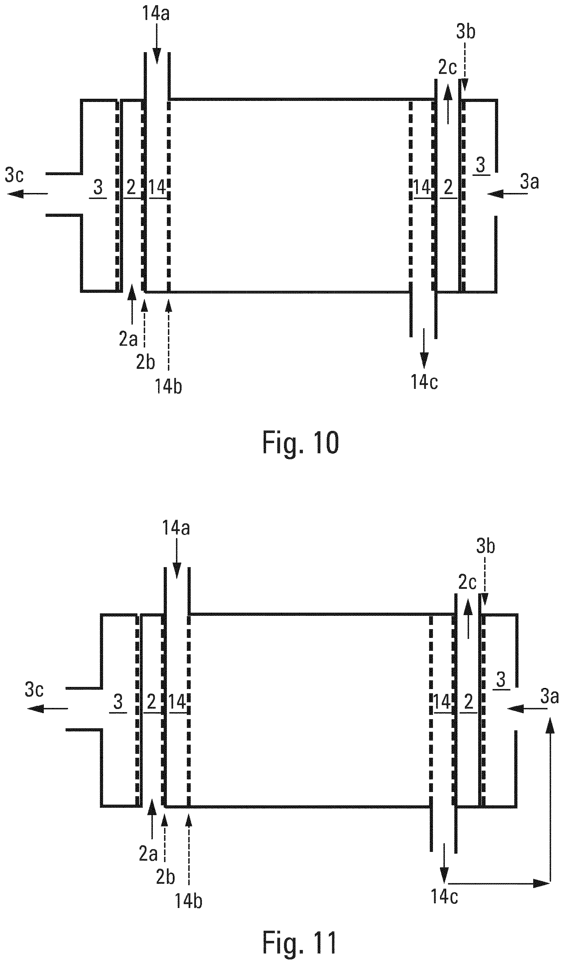

Ces différentes parties sont reprises schématiquement dans les figures 10 et 11.

Dans un premier exemple selon la figure 10, l'échangeur dispose de deux circuits distincts pour la circulation des premier et second fluides froids. Cela permet de réguler de manière distincte le flux thermique traversant d'une part les ensembles thermoélectriques centraux 11 de forme cylindrique, et d'autre part les ensembles thermoélectriques périphériques 19 de forme parallélépipédique. Ce type de générateur est alors appelé « tri-fluide » car il gère la distribution de trois fluides distincts, à savoir le fluide chaud et les premier et second fluides froids.

Dans la configuration présentée en figure 10, le premier fluide froid circule dans des canaux 3 en contre-courant avec le fluide chaud dans les canaux 2, tandis que le second fluide froid circule dans des canaux 14 en co-courant. Cependant, il est possible de faire circuler simultanément les deux fluides froids en contre-courant de l'écoulement du fluide chaud.

Dans un second exemple selon la figure 11, l'échangeur dispose d'un seul circuit de fluide froid. Dans ce cas, le second fluide froid sortant par la sortie 14c est réinjecté directement dans l'entrée 3a du premier fluide froid grâce à un retour en forme de U. Le premier et le second fluides froids sont ainsi confondus, et ne consistent qu'en un unique fluide froid cheminant à la fois dans les canaux 3 et 14.

Ce fluide froid peut ainsi circuler dans un premier temps en co-courant au sein du premier tronçon, puis en contre-courant dans un second temps au sein du second tronçon, par rapport à l'écoulement du fluide chaud.

Dans les deux exemples, une isolation thermique est réalisée sur les tubes ronds 10 dans lesquels circule le fluide froid, précisément au niveau de la zone d'entrée et de sortie du fluide chaud dans les tubes hexagonaux 18. De la même manière, une isolation thermique est réalisée sur les tubes hexagonaux 18 dans lesquels circule le fluide chaud, au niveau de la zone d'entrée du fluid froid dans les tubes rectangulaires 20. Pour le second exemple de la figure 11, une isolation thermique supplémentaire est réalisée sur les tubes hexagonaux 18 au niveau de la zone de sortie du premier tronçon du fluide froid des tubes rectangulaires 20. Le but de l'isolation thermique est d'éviter un refroidissement prématuré du fluide chaud et/ou un échauffement prématuré du fluide froid en amont de la partie active de l'échangeur où s'effectue la génération d'électricité.

Les configurations montrées aux figures citées ne sont que des exemples possibles, nullement limitatifs, de l'invention qui englobe au contraire les variantes de formes et de conceptions à la portée de l'homme de l'art, ainsi que les variations dimensionnelles et quantitatives des modules thermoélectriques au sein d'un générateur.

## Revendications

1. Module 1' thermoélectrique comprenant un ensemble thermoélectrique central 11 de forme tubulaire cylindrique à l'intérieur duquel circule un premier fluide froid et à l'extérieur duquel circule un fluide chaud,
**caractérisé en ce qu'**il comprend également au moins un ensemble thermoélectrique périphérique 13, 19 présentant :
- une face externe en contact avec un second fluide froid ;
- une face interne disposée sur une limite périphérique entourant l'ensemble thermoélectrique central 11, ladite limite définissant un canal 2 entre lesdits ensembles thermoélectriques central 11 et périphérique 13,19 où circule le fluide chaud,
dans lequel le module comprend un ensemble thermoélectrique périphérique (13) disposé de façon continue sur la limite périphérique.

2. Module 1' thermoélectrique selon l'une des revendications précédentes, **caractérisé en ce que** l'ensemble thermoélectrique central 11 se trouve à l'intérieur de l'ensemble thermoélectrique périphérique 13.

3. Module 1' thermoélectrique selon l'une des revendications précédentes, **caractérisé en ce que** ledit ensemble thermoélectrique périphérique 13 est de forme tubulaire cylindrique parallèle et concentrique avec l'ensemble thermoélectrique central 11.

4. Module 1' thermoélectrique selon l'une des revendications précédentes, **caractérisé en ce que** lesdits ensembles thermoélectriques central 11 et périphérique 13 sont chacun formés par un alignement d'éléments thermoélectriques de forme annulaire, reliés électriquement les uns aux autres et susceptibles de générer un courant électrique sous l'action d'un gradient de température exercé entre deux de leurs faces.

5. Module 1' thermoélectrique selon l'une des revendications précédentes, **caractérisé en ce que** ledit canal 2 à l'intérieur duquel circule le fluide chaud a une section annulaire.

6. Module 1' thermoélectrique selon l'une des revendications précédentes, **caractérisé en ce que** le canal 2 dans lequel circule le fluide chaud comprend des moyens de perturbation de l'écoulement du fluide chaud.

7. Module 1' thermoélectrique selon la revendication précédente, **caractérisé en ce que** lesdits moyens de perturbation de l'écoulement du fluide chaud consistent en des ailettes 17 positionnées au sein du canal d'écoulement du fluide chaud et s'étendant depuis la face externe de l'ensemble thermoélectrique central 11 et depuis la face interne de l'ensemble thermoélectrique périphérique 13.

8. Module 1' thermoélectrique selon la revendication précédente, **caractérisé en ce que** lesdites ailettes 17 s'étendant depuis les ensembles thermoélectriques central 11 et périphérique 13 sont disposées en quinconce.

9. Module 1' thermoélectrique selon l'une des revendications précédentes, **caractérisé en ce que** les ensembles thermoélectriques central 11 et périphérique 13 sont reliés électriquement en parallèle.

10. Dispositif thermoélectrique comprenant un agencement d'une pluralité de modules 1' thermoélectriques selon l'une quelconque des revendications précédentes.

11. Dispositif thermoélectrique selon la revendication précédente, **caractérisé en ce que** les modules 1' thermoélectriques sont disposés en ligne.

12. Dispositif thermoélectrique selon l'une des revendications 10 et 11, **caractérisé en ce que** les modules 1' thermoélectriques sont disposés en quinconce.

13. Générateur thermoélectrique comprenant au moins un dispositif thermoélectrique selon l'une des revendications 10 à 12.

## Patentansprüche

1. Thermoelektrisches Modul 1', welches eine zentrale thermoelektrische Anordnung 11 von zylindrischer rohrförmiger Gestalt umfasst, in deren Innerem ein erstes kaltes Fluid zirkuliert und außerhalb von der ein warmes Fluid zirkuliert,
**dadurch gekennzeichnet, dass** es außerdem wenigstens eine periphere thermoelektrische Anordnung 13, 19 umfasst, welche aufweist:
- eine Außenseite, die sich in Kontakt mit einem zweiten kalten Fluid befindet;
- eine Innenseite, die an einer Umfangsgrenze angeordnet ist, welche die zentrale thermoelektrische Anordnung 11 umgibt, wobei diese Grenze einen Kanal 2 zwischen der zentralen 11 und der peripheren 13, 19 thermoelektrischen Anordnung definiert, wo das warme Fluid zirkuliert,
wobei das Modul eine periphere thermoelektrische Anordnung (13) umfasst, welche durchgehend an der Umfangsgrenze angeordnet ist.

2. Thermoelektrisches Modul 1' nach einem der vorhergehenden Ansprüche, **dadurch gekennzeichnet, dass** die zentrale thermoelektrische Anordnung 11 sich im Inneren der peripheren thermoelektrischen Anordnung 13 befindet.

3. Thermoelektrisches Modul 1' nach einem der vorhergehenden Ansprüche, **dadurch gekennzeichnet, dass** die periphere thermoelektrische Anordnung 13 von einer zylindrischen rohrförmigen Gestalt ist, die zu der zentralen thermoelektrischen Anordnung 11 parallel und konzentrisch ist.

4. Thermoelektrisches Modul 1' nach einem der vorhergehenden Ansprüche, **dadurch gekennzeichnet, dass** die zentrale 11 und die periphere 13 thermoelektrische Anordnung jeweils von einer Aneinanderreihung thermoelektrischer Elemente von ringförmiger Gestalt gebildet werden, die elektrisch miteinander verbunden sind und geeignet sind, unter der Einwirkung eines zwischen zwei ihrer Seiten hervorgerufenen Temperaturgradienten einen elektrischen Strom zu erzeugen.

5. Thermoelektrisches Modul 1' nach einem der vorhergehenden Ansprüche, **dadurch gekennzeichnet, dass** der Kanal 2, in dessen Innerem das warme Fluid zirkuliert, einen ringförmigen Querschnitt aufweist.

6. Thermoelektrisches Modul 1' nach einem der vorhergehenden Ansprüche, **dadurch gekennzeichnet, dass** der Kanal 2, in welchem das warme Fluid zirkuliert, Mittel zur Störung der Strömung des warmen Fluids umfasst.

7. Thermoelektrisches Modul 1' nach dem vorhergehenden Anspruch, **dadurch gekennzeichnet, dass** die Mittel zur Störung der Strömung des warmen Fluids aus Stegen 17 bestehen, die im Inneren des Strömungskanals des warmen Fluids positioniert sind und sich von der Außenseite der zentralen thermoelektrischen Anordnung 11 und von der Innenseite der peripheren thermoelektrischen Anordnung 13 aus erstrecken.

8. Thermoelektrisches Modul 1' nach dem vorhergehenden Anspruch, **dadurch gekennzeichnet, dass** die Stege 17, die sich von der zentralen 11 und der peripheren 13 thermoelektrischen Anordnung aus erstrecken, gegeneinander versetzt angeordnet sind.

9. Thermoelektrisches Modul 1' nach einem der vorhergehenden Ansprüche, **dadurch gekennzeichnet, dass** die zentrale 11 und die periphere 13 thermoelektrische Anordnung elektrisch parallelgeschaltet sind.

10. Thermoelektrische Vorrichtung, welche eine Anordnung von mehreren thermoelektrischen Modulen 1' nach einem der vorhergehenden Ansprüche umfasst.

11. Thermoelektrische Vorrichtung nach dem vorhergehenden Anspruch, **dadurch gekennzeichnet, dass** die thermoelektrischen Module 1' in Reihe angeordnet sind.

12. Thermoelektrische Vorrichtung nach einem der Ansprüche 10 und 11, **dadurch gekennzeichnet, dass** die thermoelektrischen Module 1' gegeneinander versetzt angeordnet sind.

13. Thermoelektrischer Generator, welcher mindestens eine thermoelektrische Vorrichtung nach einem der Ansprüche 10 bis 12 umfasst.

## Claims

1. Thermoelectric module 1' comprising a central thermoelectric assembly 11 of cylindrical tubular shape inside which a first cold fluid flows and outside which a hot fluid flows,
**characterized in that** it also comprises at least one peripheral thermoelectric assembly 13, 19 having:
- an outer face in contact with a second cold fluid;
- an inner face positioned on a peripheral boundary surrounding the central thermoelectric assembly 11, said boundary defining a channel 2 between said central 11 and peripheral 13, 19 thermoelectric assemblies where the hot fluid flows,
the module comprising a peripheral thermoelectric assembly (13) positioned continuously on the peripheral boundary.

2. Thermoelectric module 1' according to one of the preceding claims, **characterized in that** the central thermoelectric assembly 11 is situated inside the peripheral thermoelectric assembly 13.

3. Thermoelectric module 1' according to either of the preceding claims, **characterized in that** said peripheral thermoelectric assembly 13 is of cylindrical tubular shape that is parallel and concentric with the central thermoelectric assembly 11.

4. Thermoelectric module 1' according to one of the preceding claims, **characterized in that** said central 11 and peripheral 13 thermoelectric assemblies are each formed by an alignment of thermoelectric elements of annular shape that are linked electrically to one another and able to generate an electric current under the action of a temperature gradient exerted between two of their faces.

5. Thermoelectric module 1' according to one of the preceding claims, **characterized in that** said channel 2 inside which the hot fluid flows has an annular cross section.

6. Thermoelectric module 1' according to one of the preceding claims, **characterized in that** the channel 2 in which the hot fluid flows comprises means for disrupting the flow of the hot fluid.

7. Thermoelectric module 1' according to the preceding claim, **characterized in that** said means for disrupting the flow of the hot fluid consist of fins 17 that are positioned within the channel for the flow of the hot fluid and extend from the outer face of the central thermoelectric assembly 11 and from the inner face of the peripheral thermoelectric assembly 13.

8. Thermoelectric module 1' according to the preceding claim, **characterized in that** said fins 17 extending from the central 11 and peripheral 13 thermoelectric assemblies are positioned in a quincunx.

9. Thermoelectric module 1' according to one of the preceding claims, **characterized in that** the central 11 and peripheral 13 thermoelectric assemblies are linked electrically in parallel.

10. Thermoelectric device comprising an arrangement of a plurality of thermoelectric modules 1' according to any one of the preceding claims.

11. Thermoelectric device according to the preceding claim, **characterized in that** the thermoelectric modules 1' are positioned in a line.

12. Thermoelectric device according to either of Claims 10 and 11, **characterized in that** the thermoelectric modules 1' are positioned in a quincunx.

13. Thermoelectric generator comprising at least one thermoelectric device according to one of Claims 10 to 12.
